(19) **Europäisches Patentamt / European Patent Office / Office européen des brevets**

(11) **EP 2 746 788 B1**

(12) **EUROPEAN PATENT SPECIFICATION**

(45) Date of publication and mention
of the grant of the patent:
**06.04.2016 Bulletin 2016/14**

(51) Int Cl.:
*G01R 29/18* (2006.01)  *H02H 3/48* (2006.01)

(21) Application number: **12460091.7**

(22) Date of filing: **21.12.2012**

(54) **A method of out of step detection in electrical power network**

Verfahren zur Aussertritt-Erkennung in einem Stromnetzwerk

Procédé de détection de déphasage dans un réseau d'alimentation électrique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**25.06.2014 Bulletin 2014/26**

(73) Proprietor: **ABB Technology AG
8050 Zürich (CH)**

(72) Inventors:
• **Krata, Jaroslaw
97-200 Tomaszow Mazowiecki (PL)**

• **Balcerek, Przemyslaw
30-389 Krakow (PL)**
• **Gajic, Zoran
723 47 Vasteras (SE)**

(74) Representative: **Chochorowska-Winiarska,
Krystyna
ABB Sp. z o. o.
ul. Zeganska 1
04-713 Warszawa (PL)**

(56) References cited:
**US-B2- 7 930 117**

**Description**

The invention relates to a method of detecting out of step presence in an electric power network. The electrical power network may be formed from two separate power systems connected together by a multiphase transmission line or from one power system and transmission line to which a generator is connected. The invention can be used also in the power network with multiple transmission lines connected to many generators, motors and loads, and in which a part of a system needs to be isolated in case of an occurrence of out of step. The invented method is used to protect a power system against the out of step condition. The method detects the out of step condition by utilizing frequency differences between current and voltages in local and remote locations.

The known methods for detecting out of step in a power system and/or transmission line are mainly based on measurements from one end of the power system and/or transmission line. For example, an impedance method utilized local measurements of current and voltage of the system in order to calculate impedance. The impedance trajectory is monitored and basing on certain allowed area of operation the condition of the appearance of the out of step is determined.

From patent application WO2010/145684 there is a known arrangement for protecting equipment of an electrical power system comprising of electric machines. This arrangement provides information about a known method for determination of power swing and/or to provide information relating to the occurrence of a pole slip in the electric power system through the utilization of the frequency of the current and the frequency of the voltage. The described patent application refers to protection equipment that is configured to measure the frequency of the current and voltage in at least one location in the electrical power system. Power swing is detected if values of the frequency of the current and voltage show that the measured current phasor starts to rotate at a different rate to the measured voltage phasor and if the relative angle between the electro-motive forces of said two theoretical electrical machines thereof is continuously increasing or decreasing. Power swing is located on a motor side if the frequency of the current measured is higher than the frequency of the voltage. Conversely, power swing is located on a generator side, if the frequency of the current is lower than the frequency of the voltage. The method can determine the described phenomenon only if the protected motor/generator is the source of the power swing.

Additionally, the method utilizes relative angle criteria, which require additional settings for determination of increasing or decreasing angle.

Utilization of measurements from both ends of the power system and/or transmission line increases protection reliability and efficiency.

From patent description US 7,930,117 there is a known method for detecting power swing and out of step using an intelligent electric device IED in the power system. The detection of out of step is based on measurements from two locations in the electrical power system. Voltage measurements may be received from the first and the second IED. The measurements may be time synchronized and utilized to calculate the difference of the angles of the voltage positive sequences between the first and the second location in the electrical power system. From the difference in angle between a local and remote IED a slip frequency and acceleration may be obtained. This allows the trajectory of slip frequency and acceleration to be monitored and compared to the operating region and a swing detection region. The angle difference, slip frequency, and acceleration may be used to detect an out of step condition in the electrical power system and/or power swing between the first location and the second location in the electrical power system. The angle difference, slip frequency and acceleration may also be used to predict the occurrence of out of step conditions in the future. However, calculating the second derivative i.e. acceleration can cause numerical errors, problem associated with the differentiation is the amplification of high frequency noise or significant computation delay. Another disadvantage of this solution is that the efficiency of the method depends on the correct setting of the operating region and swing detection region being made.

The essence of the inventive method for detecting out of step presence in an electric power network involves the use of a protection device having means for measurement voltage, VA, VB and currents signals, IA, IB of electric lines at a local and remote terminals of the electric network and having a computer means for data processing and calculating a frequency of current $f_{ll}$ and a frequency of voltage $f_{Ul}$ at the local terminal and a frequency of current $f_{lr}$ and a frequency of voltage $f_{Ur}$ at the remote terminal, calculating a value of a frequency difference $\Delta f_l$ at local terminal and a value of a frequency difference $\Delta f_r$ at remote terminal, is that it performs the following steps:

- calculating a value of difference of frequency differences $\Delta f$ between the local and between remote terminals,
- determination of criteria Crit1, Crit2, Crit3, Crit4 for out of step detection with the user setting special thresholds for each criterion, where:

- Crit1 has a form:

$$(\text{Crit1} == 1) \Leftrightarrow (abs(\Delta f_l) > f_{value\_thr})$$

where:

$abs(\Delta f_l)$ is the absolute value of frequency difference in local terminal,
$f_{value\_thr}$ is a threshold value for frequency difference in local terminal set by a user;

- Crit2 has a form:

$$(\text{Crit2} == 1) \Leftrightarrow \begin{cases} (a_l > f_{dir_{thr}}) \; AND \; (a_r < -f_{dir_{thr}}) \\ OR \\ (a_l < -f_{dir\_thr}) \; AND \; (a_r > f_{dir\_thr}) \end{cases},$$

where:

$a_l$ - is monotonicity coefficient of the frequency difference for the local terminal,
$a_r$ - is monotonicity coefficient of the frequency difference for a remote terminal,
$f_{dir\_thr}$ - is a threshold value for monotonicity coefficient set by a user;

- Crit3 has a form:

$$(\text{Crit3} == 1) \Leftrightarrow (sgn(\Delta f_l) \neq sgn(\Delta f_r))$$

where:

$sgn(\Delta f_l)$ - signum function for local terminal,
$sgn(\Delta f_r)$ - signum function for remote terminal,
$\Delta f_l$ - is frequency difference at local terminal,
$\Delta f_r$ - is frequency difference at remote terminal;

- Crit4 has a form:

$$(\text{Crit4} == 1) \Leftrightarrow (abs(\Delta f) > f_{diff\_thr})$$

where:

$\Delta f$ - is value of difference of frequency differences in local and remote terminal,
$abs(\Delta f)$ - is absolute value of difference of frequency differences in local and remote terminal,
$f_{diff\_thr}$ - is a threshold value for difference of frequency difference setting by a user;

- determination out of step presence by making a logic product of the results of all of the criteria Crit1, Crit2, Crit3, Crit4 for each sample of interest at the same time instant and when the result of the logic product is 1" the out of step is detected,
- automatically creating a signal to activate remedial action, triggering an alarm and/or passing the signal indicating the out of step detection to other protection devices.

Preferably a monotonicity coefficient $a_l$ of the frequency difference for the local terminal is calculated according a numerical implementation of the Least Squares method according to formulas:

$$a_l = \frac{n \sum_{i=1}^{n} t_{k-n+i} \Delta f_{lk-n+i} - \sum_{i=1}^{n} t_{k-n+i} \cdot \sum_{i=1}^{n} \Delta f_{lk-n+i}}{n \sum_{i=1}^{n} t_{k-n+i}^2 - \left(\sum_{i=1}^{n} t_{k-n+i}\right)^2}$$

where:

$n$ - number of samples used in the calculation, given by user,
$t_k$ - k-time instant,
$i$ - number of iteration,

and a monotonicity coefficient $a_r$ of the frequency difference for remote terminal is calculated according a numerical implementation of Least Squares method according to formulas:

$$a_r = \frac{n \sum_{i=1}^{n} t_{k-n+i} \Delta f_{rk-n+i} - \sum_{i=1}^{n} t_{k-n+i} \cdot \sum_{i=1}^{n} \Delta f_{rk-n+i}}{n \sum_{i=1}^{n} t_{k-n+i}^2 - \left(\sum_{i=1}^{n} t_{k-n+i}\right)^2}$$

where:

$n$ - number of samples used in the calculation, given by user, typically set as 5,
$t_k$ - k-time instant,
$i$ - number of iteration in formula.

Preferably a difference of frequency differences $\Delta f$ in local and remote terminal is calculated in the following way:

$$\Delta f = \Delta f_l - \Delta f_r$$

where:

$\Delta f_l$ - is frequency difference at local terminal,
$\Delta f_r$ - is frequency difference at remote terminal.

The essence of a device for implementing the method according to claims 1-3 of out of step detection in an electric power network, comprising means for measuring electric data in a local and a remote terminal and a computer means for processing the measured data in the form of a protection relay, is that it also comprises the following means embedded in the functional modules of the protection system of the protection relay,

- means for calculating an absolute value of frequency difference $abs(\Delta f_l)$ in the local terminal,
- means for calculating monotonicity coefficients of the frequency difference $a_l$ of the frequency difference for a local terminal and $a_r$ for a remote terminal,
- means for calculating signum functions $sgn(\Delta f_l)$ for a local terminal and $sgn(\Delta_{fr})$ for a remote terminal,
- means for calculating an absolute value of difference of frequency differences $abs(\Delta f)$ in a local and a remote terminal, and where:
- means for setting and checking the criteria Crit1, Crit2, Crit3, Crit4 are embedded in an out of step detection module and in a setting module of the protection system,
- means for calculating a logic product of the all criteria Crit1, Crit2, Crit3, Crit4 are embedded in an out of step detection module,
- means for activation of remedial action and/or alarming the user by signal when the result of the logic sum is "1" are embedded in the out of step detection module.

Preferably the input of the out of step detection module is connected with the setting module and with a frequency differences calculating module.
Preferably the protection relay has a form of Intelligent Electronic Device IED.

Preferably the Intelligent Electronic Device IED is IED670 produced by ABB company.

Preferably the local and remote terminals are electrically connected by communications link through protective relays.

A computer program product comprising computer code which when executed in a computing device carries out of the steps of a method according to the claims 1-3.

The invented method has a number of advantages over other known methods. First, due to the utilization of measurements from more than one point in the system it is able to achieve high reliability. The set of different criteria ensures that the method does not cause false alarm signals. There are no unstable mathematical operations such as derivative calculation that may cause instability of the method. Moreover, the method is easily configured as it only requires a few settings.

The method for executing the invention is presented in exemplary embodiments in the drawings where:

Fig.1 - shows schematically the first electrical power network with two power systems,

Fig.2 - the second electrical power network with one power system and one generator,

Fig.3 - the third electrical power network with multiple transmission lines,

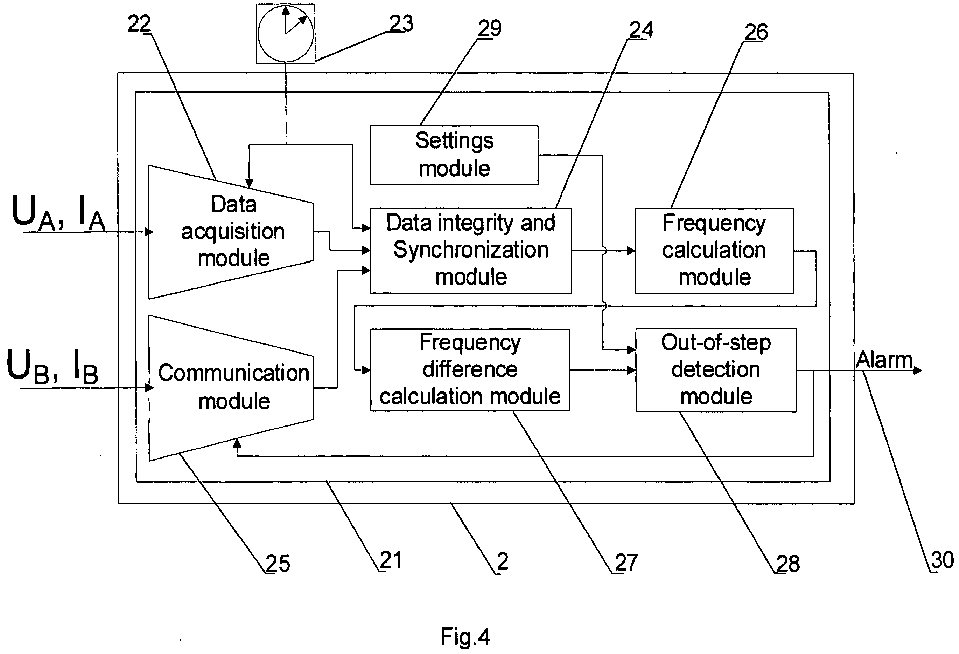

Fig.4 - a schematic diagram of a protection relay device adapted to execute the method according to the invention,

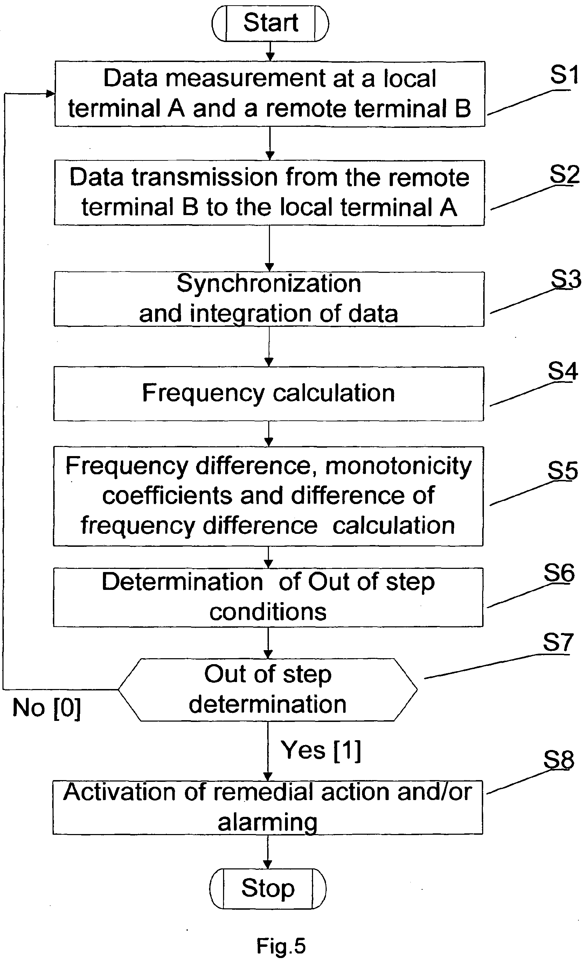

Fig.5 -the sequence of actions performed to execute the method according to the invention,

Fig.6 - the details of step S6 from fig.5,

Fig.7 - diagram of out of step determination for the function of frequency differences in the time domain.

The invention is presented in exemplary embodiments where three different electrical power networks are used.

In the first embodiment of the invention the electrical power network has two power systems, a first power system PS1 and a second power systems PS2. The two power systems PS1 and PS2 are connected together by a three-phase transmission line 1. The transmission line is equipped with two measuring terminals, a first local terminal A and the second remote terminal B. Local terminal A can also be the remote terminal B where the remote terminal B plays the role of local terminal A. Each of the terminals have an electrical connection with commonly known protection relays 2. In both terminals A and B the sensors 3 for measuring voltage and current from the power systems PS1 and PS2 are located. Such sensors 3 may be connected to the protection relays 2, or other microcomputer devices for gathering and processing the measured data. In order to simplify the understanding of the invention only the protection relay 2 is presented as such a device. Each of the relays 2 has special modules for detecting an out of step condition in the power system PS1 or PS2. The details of such module are explained in other parts of the description. Both protection relays 2 have communications means for providing communication link between them, which for example may be a wire link 4. Instead of wire link 4 the communication may be realized by wireless connection means.

In the second embodiment of the invention the electrical power network has the power system PS1 which is connected with the generating unit 5 through transmission line 1. In this embodiment the local terminal A is located directly in powers system PS1, which is indicated in a symbolic way placing the letter A in the box PS1, and the remote terminal B is located on the line 1 between the power system PS1 and the generating unit 5. The terminals A and B are connected with the protection relays 2 playing a similar role as that which was described in the first embodiment of the invention. Both protection relays 2 have means for providing communication links between them, which for example may be a wire link 4. Instead of wire link 4 the communication may be realized by wireless connection means.

In the third embodiment of the invention the electrical power network has a form of many transmission lines 1 where each of the lines connects the power systems PS1 ... $PS_N$ (where N is a natural number) with another power system, or with the generating units 5 or with loads 6. The transmission lines 1 have local terminals A and remote terminal B located on at least one the same line 1. The terminals A and B are connected with the protection relay 2 playing the similar role as in the first and second embodiment. Instead of wire link 4 the communication may be realized by wireless connection means.

In all exemplary embodiments of the invention, the first and the second protection relays 2 are used as devices for measuring, gathering and processing data. It is not important which protection relay 2 is the first or second relay because all relays used in the invented method are identical devices. The relays 2 are electrically connected to the line 1 in the measuring terminals A or B directly with all three phases of the line 1. Located in each of the measured terminals is a means for measuring current and voltage and these means are electrically connected with means for receiving a value of the measured data, located in the protection relay 2. The means for receiving values of the measured data in terminal A and B are placed in the protection system 21 of the relay 2, in which many functional modules are implemented.

A data acquisition module 22 for local measurement is placed in the protection system 21. The data acquisition module 22 is synchronized by clock 23, placed inside the protection relay 2, with or without the protection system 21. The data acquisition module 22 is connected with a data synchronization and integrity module 24 for time synchronization of local and remote measured data with utilization of the clock 23. The data synchronization and integrity module 24 is connected with a communication module 25 for receiving remote measurements of voltage and current. The data synchronization and integrity module 24 also is connected with a frequency calculation module 26 for calculating the frequency of measured signals and for processing the data for subsequent steps realized in the method. The frequency calculation module 26 is connected with a frequency differences calculation module 27 for calculating the frequency differences between local and remote measured data. The frequency differences calculation module 27 is connected with an out of step detection module 28 for comparing the values of the measured and processed data and to determine out of step detection criteria Crit1, Crit2, Crit3, Crit4, implemented by the inventive method and for receiving the logic value of such a comparison. The out of step detection module 28 is also connected with a setting module 29 for determining an occurrence of out of step phenomenon. Module 28 is connected to signal 30 for activating a remedial action by sending an appropriate alarm from the out of step detection module 28 to outside the protection system 21. The alarm signal 30 is also connected with the communication module 25 for communicating a detection of out of step. The protection system 21 is connected also with means for visualizing the result of the detection, which is not presented in the drawing. Besides incorporating the protection system, the protection relay 2 contains many other functional modules which are not the subject of the invention. Protection relay 2 could be any device in the form of an IED devices (Intelligent Electronic Device). Preferably, the IED device known under the name IED670 series produced by ABB is used as the protection relay 2.

The invention is realized in the following steps S1-S8

### Step S1

### Data measurement at a local terminal A and a remote terminal B

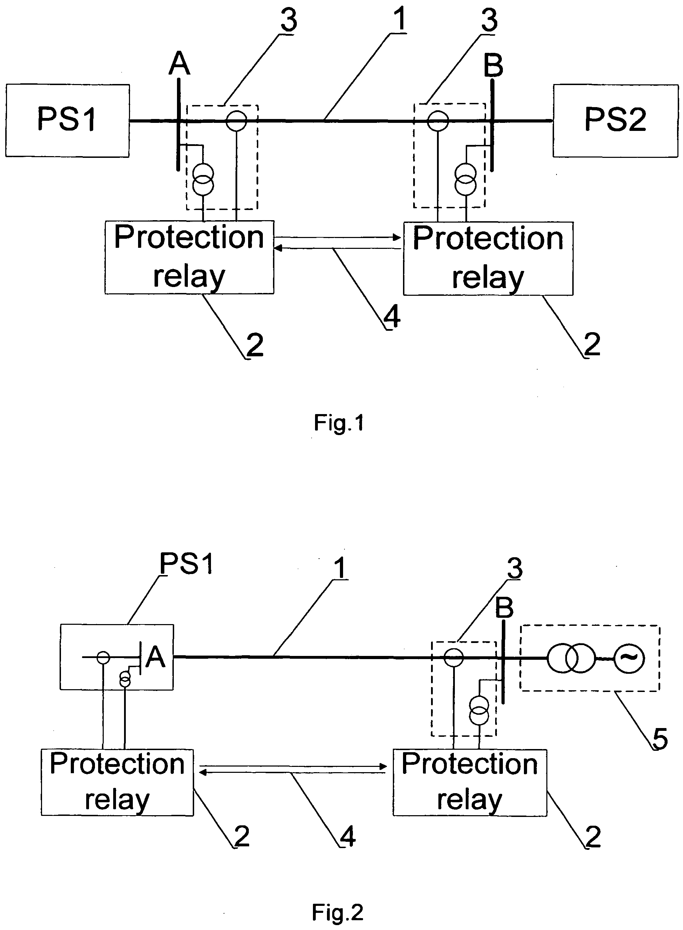

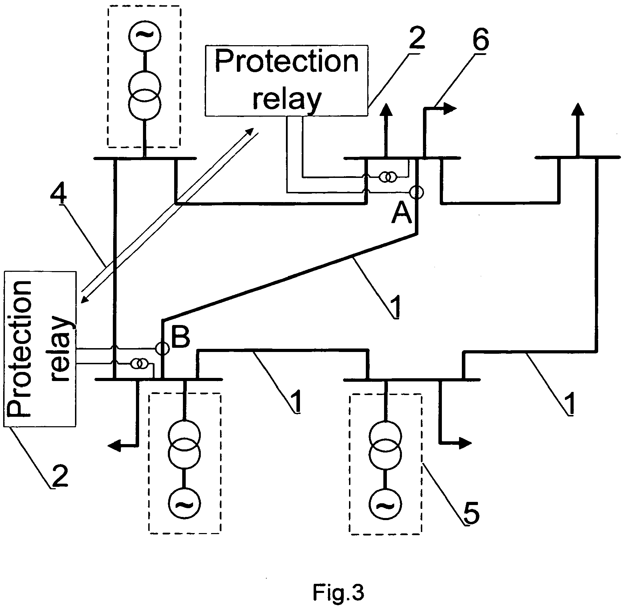

First, the three phase current $I_A$ and voltage $V_A$ signals at a local terminal A of a transmission line 1 are measured by common known sensors 3. The measured signals from terminal A are transmitted to the device for measuring and processing data, this device being a first protection relay 2 equipped with protection system 21. The measured signals are acquired by module 22. Terminal A can be located on the transmission line between two power systems PS1 and PS2 as presented in fig.1, or between the power system PS1 and generating unit 5 as presented in fig.2, or in any place of the multiterminal power system PS1... PSn as presented in fig.3. In the protection system 21 the values of the measured the three phase voltage signal $V_A$ and the measured three phase current signal $I_A$ are gathered and recorded.

Second, the current $I_B$ and voltage $V_B$ signals at a remote terminal B of the transmission line 1 are measured by common known sensors 3. The measured signals are acquired by module 22 of the protection system of the second protection relay 2 in the same way as for terminal A.

After the measurements, the signals $I_A$, $I_B$ $V_A$, $V_B$ are sampled and digitalized using the protection relay 2. For this purpose in every time instant $t_k$, where k is a present time instant, according to sampling frequency $f_s$ the data is digitized in a known way. The sampling frequency $f_s$ can be fixed or variable and it is established by user - typical values of sampling frequency are between 1kHz-10kHz.

### Step S2

### Data transmission from the remote terminal B to the local terminal A

Next, the three phase measured signals $I_B$ and $V_B$ are transmitted from terminal B to the terminal A for further processing utilizing communication link 4. The measured signals are received by a communication module 25 of protection system 21 of the first protection relay 2. In the protection system 21 of the first protection relay 2 the values of the received signals at the terminal B are gathered and recorded.

### Step S3

### Synchronization and integration of data

At the step S3 which is executed in module 24 of protection system 21 of protection relay 2, the data from local terminal A and the remote terminal B is time-synchronized in order to run further processes on the data with the same time stamps. The data is synchronized according to the clock 23.

**Step S4**

**Frequency calculation**

At step S4 a frequency of current and a frequency of voltage from both terminals A and B is calculated using the data obtained in step 3. The calculation takes place in frequency calculation module 26 of the protection system 21 and is realized in one of known way. As the result of calculation of frequencies the following values are obtained:

$f_{Ul}$- frequency of voltage in local terminal,

$f_{Il}$ - frequency of current in local terminal,

$f_{Ur}$ - frequency of voltage in remote terminal.

**Step S5**

**Frequency difference, monotonicity coefficients and difference of frequency difference calculation**

At step S5 a value of difference of frequency differences in local and remote terminals A and B are calculated from data obtained in step S4. The step is executed in the frequency differences calculation module 27 of the protection system 21.
First, a value of a frequency difference at local terminal A is calculating according to the formula:

$$\Delta f_l = f_{Ul} - f_{Il} \qquad\qquad (1)$$

**where:**

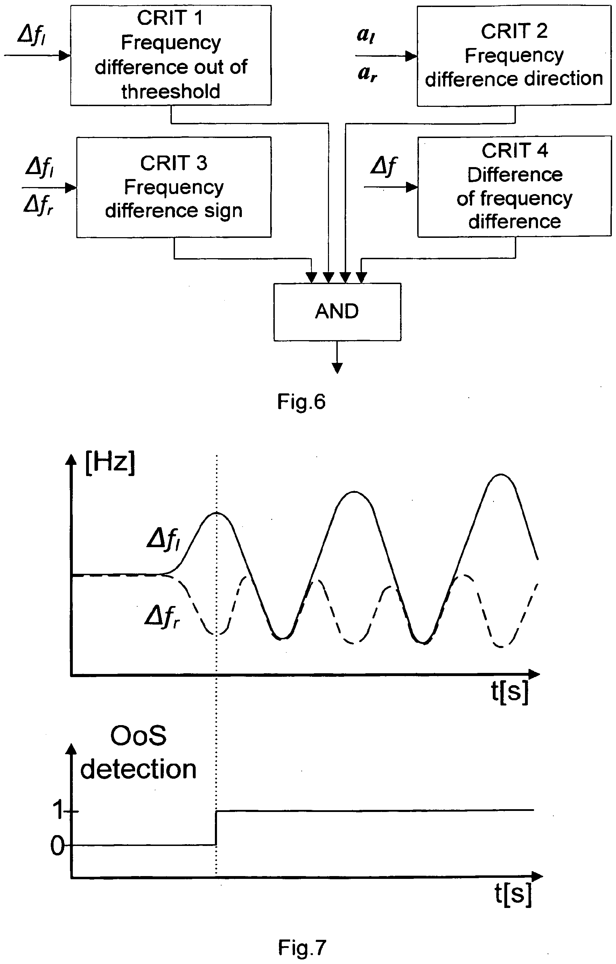

$\Delta f_l$ - is a value of the frequency difference at local terminal A presented in fig.7a,
$f_{Ul}$ - is a value of the frequency of voltage in local terminal A,
$f_{Il}$ - is the frequency of current in local terminal A.

Second, a value of a frequency difference at remote terminal B is calculating according to the formula:

$$\Delta f_r = f_{Ur} - f_{Il} \qquad\qquad (2)$$

where:

$\Delta f_r$ - is frequency difference at remote terminal B presented in fig.7a,
$f_{Ur}$ - frequency of voltage in remote terminal B,
$f_{Il}$ - is the frequency of current in local terminal A.

Next, a frequency difference direction is calculated. The frequency difference direction expresses the monotonicity of frequency difference and is determined for local terminal A by a monotonicity coefficient of the frequency difference $a_l$ and for remote terminal B by the monotonicity coefficient of the frequency difference $a_r$. In order to receive such coefficients one of the methods of monotonicity implementation should be applied. There are many known methods for calculating monotonicity. In this invention, the linear regression coefficient method is calculated using the numerical implementation of Least Squares method known in the state of the art according to formulas:

$$a_l = \frac{n\sum_{i=1}^{n} t_{k-n+i}\Delta f_{lk-n+i} - \sum_{i=1}^{n} t_{k-n+i}\cdot\sum_{i=1}^{n} \Delta f_{lk-n+i}}{n\sum_{i=1}^{n} t_{k-n+i}^2 - \left(\sum_{i=1}^{n} t_{k-n+i}\right)^2} \qquad (3)$$

where:

$n$ - number of samples used in the calculation, given by user, typically set as 5,

$t_k$ - k-time instant,

$i$ - number of iteration.

$$a_r = \frac{n\sum_{i=1}^{n} t_{k-n+i}\Delta f_{rk-n+i} - \sum_{i=1}^{n} t_{k-n+i}\sum_{i=1}^{n}\Delta f_{rk-n+i}}{n\sum_{i=1}^{n} t_{k-n+i}^2 - \left(\sum_{i=1}^{n} t_{k-n+i}\right)^2} \tag{4}$$

where:

$n$ - number of samples used in the calculation, given by user, typically set as 5,

$t_k$ - k-time instant,

$i$ - number of iteration in formula.

Next, the difference of frequency difference $\Delta f$ is calculated in order to avoid false out of step detection when frequency differences are close together and small disturbances in direction and values could trigger certain other criteria. The difference of frequency differences in a local and a remote terminal is calculated in the following way:

$$\Delta f = \Delta f_l - \Delta f_r \tag{5}$$

where:

$\Delta f$- is difference of frequency differences in local and remote terminal,

$\Delta f_l$ - is frequency difference at local terminal A,

$\Delta f_r$ - is frequency difference at remote terminal B.

**Step S6**

**Determination of Out of step conditions**

At step S6 the four criteria **Crit1, Crit2, Crit3, Crit4** are checked in order to prepare the signals of logic value "1" or "0". The step S6 is executed in the out of step detection module 28 of protection system 21 and is described in details in fig.6.

- The first criterion **Crit1** relies on comparison of an absolute value of frequency difference in local terminal $abs(\Delta f_l)$ with the value of a threshold $f_{value\_thr}$ given by the user in module 29 of protection system 21.

$$(Crit1 == 1) \Leftrightarrow (abs(\Delta f_l) > f_{value\_thr}) \tag{6}$$

where:

$abs(\Delta f_l)$ - is an absolute value of frequency difference in local terminal,

$f_{value\_thr}$ - is a threshold value for frequency difference in local terminal A setting by a user in the module 29, typically set to 0.4Hz.

When Crit1 == 1 it means true.

When the criterion **Crit1** is met, the result of this step is 1. In the opposite case the result is 0.

- The second criterion **Crit2** relies on the determination of the frequency difference direction. The monotonicity coefficients calculated for local and remote frequency differences are compared with the value of a threshold $f_{dir\_thr}$ given by the user in the setting module 29 of protection system 21. Out of step existence is considered if following formula is fulfilled:

$$(\text{Crit2} == 1) \Leftrightarrow \begin{cases} (a_l > f_{dir_{thr}}) \; AND \; (a_r < -f_{dir_{thr}}) \\ OR \\ (a_l < -f_{dir\_thr}) \; AND \; (a_r > f_{dir\_thr}) \end{cases} \quad (7)$$

where:

$a_l$ - is monotonicity coefficient of the frequency difference for local terminal A,

$a_r$ - is monotonicity coefficient of the frequency difference for remote terminal B,

$f_{dir\_thr}$ - is a threshold value for monotonicity coefficient, setting by a user in the module 29 and is typically 0.0001Hz.

Crit2 == 1- means true

When the criterion **Crit2** is met the result of this step is 1. In the opposite case the result is 0.

- The third criterion **Crit3** relies on examination of the sign of the frequencies difference. The criterion describes the situation in which frequency differences at local and remote terminal have opposite signs.

$$(\text{Crit3} == 1) \Leftrightarrow (sgn(\Delta f_l) \neq sgn(\Delta f_r)) \quad (8)$$

where:

$sgn(\Delta f_l)$ - signum function for local terminal A;

$sgn(\Delta f_r)$ - signum function for remote terminal B,

$\Delta f_l$ - is frequency difference at local terminal A,

$\Delta f_r$ - is frequency difference at remote terminal B.

When Crit3 == 1- it means true

When the criterion **Crit3** is met the result of this step is 1. In the opposite case the result is 0.

- The fourth criterion **Crit4** relies on comparison of absolute value of difference of frequency differences at local and remote terminals with the threshold $f_{diff\_thr}$ given by the user in module 29 of protection system 21 of protection relay 2.

$$(\text{Crit4} == 1) \Leftrightarrow \left( abs(\Delta f) > f_{diff\_thr} \right) \quad (9)$$

where:

$\Delta f$ - is value of difference of frequency differences in local and remote terminal,

$abs(\Delta f)$ - is absolute value of difference of frequency differences in local and remote terminal,

$f_{diff\_thr}$ - is a threshold value for difference of frequency difference setting by a user in the module 29. The typical value is 0.5Hz

When Crit4 == 1- it means true.

When the criterion **Crit4** is met the result of this step is 1. In opposite case the result is 0.
At the step S6 the all criteria **Crit1, Crit2, Crit3, Crit4** are checked during the action of the system and the result "0" or "1" is checking in continuous way. When all the criteria are fulfilled, the step S6 gives signal of logic 1 - true. In opposite situation step S6 gives the signal of logic 0 - false.

**Step S7**

**Out of step determination**

At the step S7 the condition for appearance of out of step is checked in such a way that when result of step S6 is "1" then the out of step is determined for a detection time $t_d$, what is presented in fig.7b and then the next step S8 is performed. In the opposite situation, the method returns back to step S1 and processes the method in iterative way. Step S7 is executed in module 28 of protection system 21.

**Step S8**

**Activation of remedial action and/or alarming**

At this step the detection signal is automatically released in order to activate remedial action, alarm or pass the tripping signal further to next devices e.g. circuit breakers. The step S8 is presented as the output signal 30 of protection system 21 which can be set on the output of the protection system 21 in protection relay 2 or send to communication module for further processes.

**Claims**

1. A method of detecting out of step presence in an electric power network making use of a protection device having means (3) for measuring voltage ($V_A$, $V_B$) and current signals ($I_A$, $I_B$) of electric lines (1) at a local (A) and remote (B) terminals of the electric network and having a computer means (2) for data processing and calculation of a frequency of current $f_{Il}$ and a frequency of voltage $f_{Ul}$ at the local terminal (A) and a frequency of current $f_{Ir}$ and a frequency of voltage $f_{Ur}$ at the remote terminal (B), calculating a value of a frequency difference $\Delta f_l$ at the local terminal (A) and a value of a frequency difference $\Delta f_r$ at the remote terminal (B), the method further comprises the following steps:

   - calculating a value of difference of frequency differences $\Delta f$ between the local and between the remote terminals,
   - determination of criteria Crit1, Crit2, Crit3, Crit4 for out of step detection and setting up by user of a special thresholds for each criterion, where:

     - Crit1 has a form:

$$(\text{Crit1} == 1) \Leftrightarrow (abs(\Delta f_l) > f_{value\_thr})$$

     where:

       $abs(\Delta f_l)$ is the absolute value of frequency difference in the local terminal (4),
       $f_{value\_thr}$ is a threshold value for frequency difference in the local terminal (A) set by a user;

     - Crit2 has a form:

$$(\text{Crit2} == 1) \Leftrightarrow \begin{cases} (a_l > f_{dir_{thr}}) \text{ AND } (a_r < -f_{dir_{thr}}) \\ \qquad\qquad OR \\ (a_l < -f_{dir\_thr}) \text{ AND } (a_r > f_{dir\_thr}) \end{cases},$$

     where:

       $a_l$ - is a monotonicity coefficient of the frequency difference for the local terminal (A)
       $a_r$ - is a monotonicity coefficient of the frequency difference for the remote terminal (B),
       $f_{dir\_thr}$ - is a threshold value for monotonicity coefficient set by a user;

- Crit3 has a form:

$$(\text{Crit3} == 1) \Leftrightarrow (sgn(\Delta f_l) \neq sgn(\Delta f_r))$$

where:

$sgn(\Delta f_l)$ - signum function for the local terminal (A),
$sgn(\Delta f_r)$ - signum function for the remote terminal (B),
$\Delta f_l$ - is a frequency difference at the local terminal (A),
$\Delta f_r$ - is a frequency difference at the remote terminal (B),

- Crit4 has a form:

$$(\text{Crit4} == 1) \Leftrightarrow (abs(\Delta f) > f_{diff\_thr})$$

where:

$\Delta f$- is value of difference of frequency differences in the local (A) and remote (B) terminals
$abs(\Delta f)$- is absolute value of difference of frequency differences in the local (A) and remote (B) terminals,
$f_{diff\_thr}$ - is a threshold value for difference of frequency difference set by a user;

- determination of out of step presence by making a logic product of the results of the all criteria **Crit1,** Crir2, Crit3, Crit4 for each sample of interest at the same time instant and when the result of the logic product is "1" the out of step is detected,
- automatically creating a signal for activate remedial action, triggering alarm or pass the signal indicating the out of step detection to other protection devices.

2. The method according to claim 1, **characterized in that**:

a monotonicity coefficient $a_l$ of the frequency difference for local terminal is calculated according a numerical implementation of a Least Squares method according to formula:

$$a_l = \frac{n \sum_{i=1}^{n} t_{k-n+i} \Delta f_{lk-n+i} - \sum_{i=1}^{n} t_{k-n+i} \cdot \sum_{i=1}^{n} \Delta f_{lk-n+i}}{n \sum_{i=1}^{n} t_{k-n+i}^2 - \left(\sum_{i=1}^{n} t_{k-n+i}\right)^2}$$

where:

$n$ - number of samples used in the calculation, given by user,
$t_k$ - k-time instant,
$i$ - number of iteration,

and a monotonicity coefficient $a_r$ of the frequency difference for remote terminal is calculated according a numerical implementation of a Least Squares method according to formula:

$$a_r = \frac{n \sum_{i=1}^{n} t_{k-n+i} \Delta f_{rk-n+i} - \sum_{i=1}^{n} t_{k-n+i} \cdot \sum_{i=1}^{n} \Delta f_{rk-n+i}}{n \sum_{i=1}^{n} t_{k-n+i}^2 - \left(\sum_{i=1}^{n} t_{k-n+i}\right)^2}$$

where:

$n$ - number of samples used in the calculation, given by user,

$t_k$ - k-time instant,

$i$ - number of iteration in formula.

**3.** The method according to claim 1-2, **characterized in that** a difference of frequency differences Δf in local and remote terminal is calculated in the following way:

$$\Delta f = \Delta f_l - \Delta f_r$$

where:

Δf- is difference of frequency differences in local and remote terminal,

$\Delta f_l$ - is frequency difference at local terminal,

$\Delta f_r$ - is frequency difference at remote terminal.

**4.** A device for implementing the method according to claims 1-3 of detecting out of step presence in an electric power network comprising means (3) for measuring electric data in both local (A) and remote (B) terminals and computer means (2) for processing measured data in the form of a protection relay (2), where means for calculation of a frequency of current $f_{ll}$ and a frequency of voltage $f_{Ul}$ at the local terminal (A) and a frequency of current $f_{lr}$ and a frequency of voltage $f_{Ur}$ at the remote terminal (B), and means for calculating a value of difference of frequency differences Δf between the local (A) and between the remote (B) terminals are embedded, **characterized in that** it further comprises the following means embedded in the functional modules of the protection system (21) of the protection relay (2),

- means for calculating an absolute value of frequency difference $abs(\Delta f_l)$ in the local terminal (A),
- means for calculating monotonicity coefficients of the frequency difference $a_l$ for the local terminal (A) and $a_r$ for the remote terminal (B),
- means for calculating signum functions $sgn(\Delta f_l)$ for the local terminal (A) and $sgn(\Delta f_r)$ for the remote terminal (B),
- means for calculating an absolute value of difference of frequency differences $abs(\Delta f)$ in the local (A) and remote terminals (B) and where:
- means for setting and checking the criteria Crit1, Crit2, Crit3, Crit4 are embedded in an out of step detection module (28) and in a setting module (29) of the protection system (21),
- means for calculating a logic product of the all criteria Crit1, Crit2, Crit3, Crit4 are embedded in an out of step detection module (28),
- means for activation of remedial action and/or alarming the user by signal (30) when the result of the logic product is "1" are embedded in the out of step detection module (28).

**5.** A device according to claim 4, **characterized in that** the input of the out of step detection module (28) is connected with the setting module (29) and with a frequency differences calculating module (27).

**6.** A device according to claim 4, **characterized in that** the protection relay (2) has a form of Intelligent Electronic Device IED.

**7.** A device according to claim 4-6, **characterized in that** the local and remote terminals are electrically connected by a communications link (4) through protective relays (2).

**8.** A computer program product comprising computer code which when executed in a computing device carriers out of the steps of a method according to the claims 1-3.

**Patentansprüche**

**1.** Ein Verfahren zur Außertritt-Erkennung in einem Stromnetzwerk, das eine Schutzeinrichtung benutzt, die Mittel (3) zur Messung der Spannungssignale $V_A$, $V_B$ und der Stromsignale $I_A$, $I_B$ der elektrischen Leitungen (1), sowohl an örtlichen (A) als auch an entfernten Stationen (B) des Stromnetzwerks, besitzt und die Computereinrichtungen (2) zur Verarbeitung und Berechnung der Stromfrequenz $f_{ll}$ und der Spannungsfrequenz $f_{Ul}$ an der örtlichen Station (A) sowie der Stromfrequenz $f_{lr}$ und der Spannungsfrequenz $f_{Ur}$ an der entfernten Station (B) besitzt, wobei sie einen Wert für die Frequenzdifferenz $\Delta f_l$ an der örtlichen Station (A) und einen Wert für die Frequenzdifferenz $\Delta f_r$ an der entfernten Station (B) berechnet, und das Verfahren darüber hinaus die folgenden Schritte beinhaltet:

- Berechnung eines Differenzwertes der Frequenzdifferenzen $\Delta f$ zwischen den örtlichen und den entfernten Stationen,
- Bestimmung der Kriterien Crit1, Crit2, Crit3, Crit4 zur Außertritt-Erkennung und Konfiguration spezieller Schwellenwerte für jedes Kriterium durch den Nutzer, wobei gilt:

- Crit1 hat die Form:

$$(\text{Crit1} == 1) \Leftrightarrow (abs(\Delta f_l) > f_{value\_thr})$$

wobei gilt:

$abs(\Delta f_l)$ - ist der Absolutwert der Frequenzdifferenz an der örtlichen Station (A),
$f_{value\_thr}$ - ist ein Schwellenwert für die Frequenzdifferenz an der örtlichen Station (A), vom Nutzer festgesetzt;

- Crit2 hat die Form:

$$(\text{Crit2} == 1) \Leftrightarrow \begin{cases} (a_l > f_{dir\_thr})AND(a_r < -f_{dir\_thr}) \\ ODER \\ (a_l < -f_{dir\_thr})AND(a_r > f_{dir\_thr}) \end{cases},$$

wobei gilt:

$a_l$ - ist der Gleichmäßigkeits-Koeffizient der Frequenzdifferenz für die örtliche Station (A)
$a_r$ - ist der Gleichmäßigkeits-Koeffizient der Frequenzdifferenz für die entfernte Station (B),
$f_{dir\_thr}$ - ist ein Schwellenwert für den Gleichmäßigkeits-Koeffizienten, vom Nutzer festgesetzt;

- Crit3 hat die Form:

$$(\text{Crit3} == 1) \Leftrightarrow (sgn(\Delta f_l) \neq sgn(\Delta f_r))$$

Wobei gilt:

$sgn(\Delta f_l)$ - ist die Signumfunktion für die örtliche Station (A),
$sgn(\Delta f_r)$ - ist die Signumfunktion für die entfernte Station (B),
$\Delta f_l$ - ist die Frequenzdifferenz an der örtlichen Station (A),
$\Delta f_r$ - ist die Frequenzdifferenz an der entfernten Station (B);

- Crit4 hat die Form:

$$(\text{Crit4} == 1) \Leftrightarrow (abs(\Delta f) > f_{diff\_thr})$$

wobei gilt:

$\Delta f$ - ist der Differenzwert der Frequenzdifferenzen zwischen den örtlichen (A) und den entfernten (B) Stationen,
$abs(\Delta f)$ - ist der Absolutwert der Differenz der Frequenzdifferenzen zwischen den örtlichen (A) und den entfernten (B) Stationen,
$f_{diff\_thr}$ - ist ein Schwellenwert für die Differenz der Frequenzdifferenzen, vom Nutzer festgesetzt;

- Erkennung des Außertritt-Zustandes im Stromnetzwerk durch Bildung eines logischen Produktes aus den Ergebnissen aller Kriterien Crit1, Crit2, Crit3, Crit4 für jede analysierte Stichprobe zum selben Zeitpunkt, und wenn das Ergebnis des logischen Produktes "1" ist, ist der Außertritt-Zustand erkannt,
- Automatische Erzeugung eines Signals zur Aktivierung von Abhilfemaßnahmen, Auslösung eines Alarms oder Übermittlung eines Signals über die Detektion des Außertritt-Zustandes im Stromnetzwerk an andere Schutzeinrichtungen.

2. Das Verfahren gemäß Anspruch 1, **dadurch gekennzeichnet, dass**:

ein Gleichmäßigkeits-Koeffizient $a_l$ der Frequenzdifferenz für die örtliche Station durch numerische Realisierung der Methode der kleinsten Quadrate gemäß der folgenden Formel berechnet wird:

$$a_l = \frac{n \sum_{i=1}^{n} t_{k-n+i} \Delta f_{lk-n+i} - \sum_{i=1}^{n} t_{k-n+i} \cdot \sum_{i=1}^{n} \Delta f_{lk-n+i}}{n \sum_{i=1}^{n} t_{k-n+i}^2 - \left(\sum_{i=1}^{n} t_{k-n+i}\right)^2}$$

wobei gilt:

$n$ - Anzahl der in der Berechnung verwendeten Stichproben, vom Nutzer vorgegeben,
$t_k$ - k-ter Zeitpunkt,
$i$ - Nummer der Wiederholung,

und ein Gleichmäßigkeits-Koeffizient $a_r$ der Frequenzdifferenz für die entfernte Station durch numerische Realisierung der Methode der kleinsten Quadrate gemäß der folgenden Formel berechnet wird

$$a_r = \frac{n \sum_{i=1}^{n} t_{k-n+i} \Delta f_{rk-n+i} - \sum_{i=1}^{n} t_{k-n+i} \cdot \sum_{i=1}^{n} \Delta f_{rk-n+i}}{n \sum_{i=1}^{n} t_{k-n+i}^2 - \left(\sum_{i=1}^{n} t_{k-n+i}\right)^2}$$

wobei gilt:

$n$ - Anzahl der in der Berechnung verwendeten Stichproben, vom Nutzer vorgegeben,
$t_k$ - k-ter Zeitpunkt,
$i$ - Nummer der Wiederholung in der Formel,

3. Das Verfahren gemäß Anspruch 1-2, **dadurch gekennzeichnet, dass** die Differenz der Frequenzdifferenzen $\Delta f$ an der örtlichen und der entfernten Station in der folgenden Weise errechnet wird:

$$\Delta f = \Delta f_l - \Delta f_r$$

wobei gilt:

$\Delta f$ - ist die Differenz der Frequenzdifferenzen an der örtlichen und der entfernten Station,
$\Delta f_l$ - ist die Frequenzdifferenz an der örtlichen Station,
$\Delta f_r$ - ist die Frequenzdifferenz an der entfernten Station.

4. Eine Einrichtung zur Ausführung des Verfahrens gemäß den Ansprüchen 1-3 zur Außertritt-Erkennung in einem Stromnetzwerk, die Mittel (3) zur Messung elektrischer Daten, sowohl in örtlichen (A) als auch in entfernten (B) Stationen, enthält sowie Computereinrichtungen (2) zur Verarbeitung der Messdaten in der Form eines Schutzrelais (2) umfasst, wobei Mittel zur Berechnung einer Stromfrequenz $f_{Il}$ und einer Spannungsfrequenz $f_{Ul}$ an der örtlichen Station (A) und einer Stromfrequenz $f_{Ir}$ und einer Spannungsfrequenz $f_{Ur}$ an der entfernten Station (B) sowie Mittel zur Berechnung der Frequenzdifferenzen $\Delta f$ zwischen den örtlichen (A) und zwischen den entfernten Stationen (B) eingebettet sind, **dadurch gekennzeichnet, dass** sie darüber hinaus die folgenden Mittel, eingebettet in die funktionalen Module des Schutzsystems (21) des Schutzrelais (2), enthält:

- Mittel zur Berechnung eines Absolutwertes von Frequenzdifferenzen *abs(Δf$_l$)* an der örtlichen Station (A),
- Mittel zur Berechnung von Gleichmäßigkeits-Koeffizienten der Frequenzdifferenz a$_l$ für die örtliche Station (A) und a$_r$ für die entfernte Station (B),
- Mittel zur Berechnung von Signumfunktionen sgn(Δf$_l$) für die örtliche Station (A) und sgn(Δf$_r$) für die entfernte Station (B),
- Mittel zur Berechnung eines Absolutwertes der Differenz von Frequenzdifferenzen zwischen der örtlichen (A) und der entfernten Station (B),
- Mittel zur Einstellung und Überprüfung der Kriterien Crit1, Crit2, Crit3, Crit4 sind eingebettet in ein Modul zur Außertritt-Erkennung (28) und in ein Einstellungsmodul (29) des Schutzsystems (21),
- Mittel zur Berechnung eines logischen Produkts aller Kriterien Crit1, Crit2, Crit3, Crit4 sind eingebettet in ein Modul zur Außertritt-Erkennung (28),
- Mittel zur Aktivierung von Abhilfemaßnahmen und/oder zur Alarmierung des Nutzers durch ein Signal (30), wenn das Ergebnis des logischen Produktes "1" ist, sind eingebettet in das Modul zur Außertritt-Erkennung (28).

5. Eine Einrichtung gemäß Anspruch 4, **dadurch gekennzeichnet, dass** die Dateneingabe des Moduls zur Außertritt-Erkennung in einem Stromwerknetz (28) mit dem Einstellungsmodul (29) und einem Berechnungsmodul für die Frequenzdifferenzen (27) verbunden ist.

6. Eine Einrichtung gemäß Anspruch 4, **dadurch gekennzeichnet, dass** das Schutzrelais (2) die Form einer intelligenten elektronischen Einrichtung IED hat.

7. Eine Einrichtung gemäß den Ansprüchen 4-6, **dadurch gekennzeichnet, dass** die örtlichen und die entfernten Stationen durch Kommunikationsverbindungen (4) elektrisch mit Hilfe der Schutzrelais (2) verbunden sind.

8. Ein Computerprogramm-Produkt, das den Computercode enthält, der nach der Inbetriebnahme in einer Computereinrichtung das Verfahren zur Außertritt-Erkennung in einem Stromnetzwerk gemäß den Ansprüchen 1-3 durchführt.

**Revendications**

1. Procédé de détection de déphasage dans un réseau d'alimentation électrique faisant l'usage d'un dispositif de protection ayant des moyens (3) pour mesurer des signaux de tension V$_A$, V$_B$ et des signaux de courant I$_A$, I$_B$ des lignes électriques (1) à des bornes locale (A) et distante (B) du réseau d'alimentation électrique et ayant un moyen informatique (2) pour le traitement de données et le calcul de la fréquence du courant f$_{Il}$ et de la fréquence de la tension f$_{Ul}$ à la borne locale (A) et de la fréquence du courant f$_{Ir}$ et de la fréquence de la tension f$_{Ur}$ à la borne distante (B) en calculant la valeur de la différence de fréquence Δf$_l$ à la borne locale (A) ainsi que la valeur de la différence de fréquence Δf$_r$ à la borne distante (B), procédé comprenant en outre les pas suivants :

- calcul de la valeur de la différence de fréquence Δf entre les bornes locale et distante,
- détermination des critères Crit1, Crit2, Crit3, Crit4 de la détection de déphasage et la configuration des seuils spéciaux pour chaque critère par un utilisateur, où :

- Crit1 a la forme :

$$(\text{Crit1} == 1) \Leftrightarrow (abs(\Delta f_l) > f_{value\_thr})$$

où :

abs(Δf$_l$) est une valeur absolue de la différence de fréquence à la borne locale (A),
f$_{values_{thr}}$ est une valeur de seuil de la différence de fréquence à la borne locale (A) déterminée par l'utilisateur ;

- Crit2 a la forme :

$$(\text{Crit2} == 1) \Leftrightarrow \begin{cases} (a_l > f_{dir\_thr}) AND (a_r < -f_{dir\_thr}) \\ ODER \\ (a_l < -f_{dir\_thr}) AND (a_r > f_{dir\_thr}) \end{cases}$$

où :

$a_r$ est un coefficient de monotonicité de la différence de fréquence à la borne locale (A),
$a_r$ est un coefficient de monotonicité de la différence de fréquence à la borne distante (B),
$f_{dir_{thr}}$ est une valeur de seuil du coefficient de monotonicité déterminée par l'utilisateur;

- Crtit3 a la forme :

$$(\text{Crit3} == 1) \Leftrightarrow (sgn(\Delta f_l) \neq sgn(\Delta f_r))$$

où :

$sgn(\Delta f_l)$ est une fonction signe (signum) pour la borne locale (A),
$sgn(\Delta f_r)$ est une fonction signum pour la borne distante (B),
$\Delta f_l$ est une différence de fréquence à la borne locale (A),
$\Delta f_r$ est une différence de fréquence à la borne distante (B),

- Crit4 a la forme :

$$(\text{Crit4} == 1) \Leftrightarrow ( abs(\Delta f) > f_{diff\_thr})$$

où :

$\Delta f$ est une valeur de différence de fréquence entre les différences de fréquence à la borne locale (A) et la borne distance (B),
$abs(\Delta f)$ est une valeur absolue de différence de fréquence à la borne locale (A) et la borne distante (B),
$f_{diff_{thr}}$ est une valeur de seuil pour la différence de différences de fréquence déterminée par l'utilisateur ;

- détermination de la présence du déphasage par le produit logique de tous les critères Crit 1, Ciri2, Crit 3, Crit 4 pour chaque échantillon analysé au même moment, et lorsque le résultat du produit logique est "1" le déphasage est détecté,
- création automatique d'un signal permettant d'activer une action correctrice, déclenchement d'une alarme ou transmission du signal indiquant la détection du déphasage à d'autres dispositifs de protection.

2. Procédé selon la revendication 1, **caractérisé en ce que** le coefficient de monotonicité $\alpha_r$ de la différence de fréquence pour la borne locale de la ligne est calculé selon la méthode des moindres carrés selon la formule :

$$a_l = \frac{n \sum_{i=1}^{n} t_{k-n+i} \Delta f_{lk-n+i} - \sum_{i=1}^{n} t_{k-n+i} \cdot \sum_{i=1}^{n} \Delta f_{lk-n+i}}{n \sum_{i=1}^{n} t_{k-n+i}^2 - \left(\sum_{i=1}^{n} t_{k-n+i}\right)^2}$$

où

$n$ - nombre d'échantillons utilisés dans le calcul, donné par l'utilisateur,
$t_k$ - k-temps momentané,
$i$ - nombre d'itérations,

et le coefficient de monotonicité $a_r$ de la différence de fréquence pour la borne distante de la ligne est calculé selon la méthode des moindres carrés selon la formule :

$$a_r = \frac{n\sum_{i=1}^{n} t_{k-n+i}\Delta f_{rk-n+i} - \sum_{i=1}^{n} t_{k-n+i} \cdot \sum_{i=1}^{n} \Delta f_{rk-n+i}}{n\sum_{i=1}^{n} t_{k-n+i}^2 - \left(\sum_{i=1}^{n} t_{k-n+i}\right)^2}$$

où

$n$ - nombre d'échantillons utilisés dans le calcul, donné par l'utilisateur,
$t_k$ - k-temps momentané,
$i$ - nombre d'itérations.

3. Procédé selon les revendications 1-2 **caractérisé en ce que** la différence de différences de fréquence $\Delta f$ entre les bornes locale et distante est calculé de façon suivante :

$$\Delta f = \Delta f_l - \Delta f_r$$

où :

$\Delta f$- est une différence de différences de fréquence entre les bornes locale et distante
$\Delta f_l$ - est une différence de fréquence à la borne locale,
$\Delta f_r$ - est une différence de fréquence à la borne distante.

4. Dispositif pour la mise en oeuvre du procédé selon les revendications 1-3 de détection de déphasage dans un réseau d'alimentation électrique, comprenant les moyens (3) pour mesurer les données électriques à tous les deux bornes locale (A) et distante (B) et les moyens informatiques (2) pour le traitement de données sous forme d'un relais de protection (2) dans lequel sont compris les moyens pour le calcul de la fréquence du courant $f_{Il}$ et de la fréquence de la tension $f_{Ul}$ à la borne locale (A) et de la fréquence du courant $f_{Ir}$ et de la fréquence de la tension $f_{Ur}$ à la borne distante (B), ainsi que les moyens pour calculer la valeur de différence de différences de fréquence $\Delta f$ entre les bornes locale (A) et distante (B) **caractérisé en ce que** le dispositif contient en outre les moyens suivants supplémentaires, compris dans les modules fonctionnels du système de protection (21) du relais de protection (2),

- moyens pour le calcul de la valeur absolue de différence de fréquence $abs(\Delta f_l)$ à la borne locale (A),
- moyens pour le calcul des coefficients de monotonicité de la différence de fréquence $a_l$ à la borne locale (A) et $a_r$ la borne distante (B),
- moyens pour le calcul de la fonction signum $sgn(\Delta f_l)$ à la borne locale (A) et $sgn(\Delta f_r)$ à la borne distante (B),
- moyens pour le calcul de la valeur absolue de différence de différences de fréquence $abs(\Delta f)$ à la borne locale (A) et à la borne distante (B), et où :
- moyens servant à déterminer et à contrôler les critères Crit1, Crit2, Crit3, Crit4 sont implantés dans le module de détection de déphasage (28) et dans le module de régulation de consignes (29) du système de protection (21),
- moyens pour calculer le produit logique de tous les critères Crit1, Crit2, Crit3, Crit4 sont compris dans le module de détection de déphasage (28),
- moyens pour activer les actions correctrices et / ou d'information pour l'utilisateur à l'aide d'un signal d'alarme (30) lorsque le résultat du produit logique est "1" est compris dans le module de détection de déphasage (28).

5. Dispositif selon la revendication 4, **caractérisé en ce que** l'entrée du module de détection de déphasage (28) est connectée au module de régulation des consignes (29) et au module de calcul de différence de fréquence (27).

6. Dispositif selon la revendication 4, **caractérisé en ce que** le relais de protection (2) a la forme de Dispositif Electronique Intelligent DEI.

7. Dispositif selon les revendications 4-6, **caractérisé en ce que** les bornes locale et distante sont connectées électriquement par l'intermédiaire d'une liaison de communication (4) du relais de protection (2).

8. Produit d'un logiciel informatique comprenant un code d'ordinateur lequel, mis en marche sur le dispositif de calcul exécute le procédé de détection de déphasage dans les réseaux électriques conformément aux pas selon les revendications 1-3.

Fig.1

Fig.2

Fig.3

Fig.4

EP 2 746 788 B1

```
                    ┌─────────────┐
                    │   Start     │
                    └──────┬──────┘
                           ▼
        ┌──────────────────────────────────┐
        │   Data measurement at a local      │      S1
        │  terminal A and a remote terminal B│
        └──────────────────┬─────────────────┘
                           ▼
        ┌──────────────────────────────────┐
        │  Data transmission from the remote │      S2
        │   terminal B to the local terminal A│
        └──────────────────┬─────────────────┘
                           ▼
        ┌──────────────────────────────────┐
        │        Synchronization             │      S3
        │      and integration of data       │
        └──────────────────┬─────────────────┘
                           ▼
        ┌──────────────────────────────────┐
        │      Frequency calculation         │      S4
        └──────────────────┬─────────────────┘
                           ▼
        ┌──────────────────────────────────┐
        │ Frequency difference, monotonicity │      S5
        │    coefficients and difference of  │
        │  frequency difference  calculation │
        └──────────────────┬─────────────────┘
                           ▼
        ┌──────────────────────────────────┐
        │  Determination  of Out of step     │      S6
        │            conditions              │
        └──────────────────┬─────────────────┘
                           ▼                         S7
              ╱───────────────────────╲
   No [0] ───┤     Out of step          ├
              ╲    determination         ╱
               ╲───────────┬───────────╱
                           │ Yes [1]
                           ▼                         S8
        ┌──────────────────────────────────┐
        │ Activation of remedial action and/or│
        │             alarming               │
        └──────────────────┬─────────────────┘
                           ▼
                    ┌─────────────┐
                    │    Stop     │
                    └─────────────┘
```

Fig.5

Fig.6

Fig.7

22

**EP 2 746 788 B1**

**Patent documents cited in the description**

- WO 2010145684 A
- US 7930117 B